(19) Europäisches Patentamt
European Patent Office
Office européen des brevets

(11) Publication number: **0 196 332**
**B1**

(12) **EUROPEAN PATENT SPECIFICATION**

(45) Date of publication of patent specification: **01.08.90**

(51) Int. Cl.[5]: **G 11 B 11/10,** H 01 F 41/18

(21) Application number: **84904169.4**

(22) Date of filing: **15.11.84**

(86) International application number:
**PCT/JP84/00547**

(87) International publication number:
**WO 85/02292 23.05.85 Gazette 85/12**

(54) **METHOD OF MANUFACTURING PHOTOTHERMOMAGNETIC RECORDING FILM.**

(30) Priority: **17.11.83 JP 216750/83**
**17.01.84 JP 6134/84**
**23.03.84 JP 55787/84**

(43) Date of publication of application:
**08.10.86 Bulletin 86/41**

(45) Publication of the grant of the patent:
**01.08.90 Bulletin 90/31**

(84) Designated Contracting States:
**DE FR GB NL**

(56) References cited:
**EP-A-0 146 985** **JP-A-5 020 300**
**EP-A-0 167 213** **JP-A-5 026 096**
**DE-A-1 940 640** **JP-A-5 613 710**

**IEEE TRANSACTIONS ON MAGNETICS MAG-20, Part 1, no. 5, September 1984, pages 983-985, New York, US; J.P. KRUMME et al.: "Bismuth-substituted iron garnet films prepared by RF diode sputtering"**

(73) Proprietor: **NIPPON SHEET GLASS CO., LTD.**
**8, Dosho-machi 4-chome Higashi-ku**
**Osaka-shi Osaka 541 (JP)**

(72) Inventor: **GOMI, Manabu**
**10-3, Sugano 6-chome**
**Ichikawa-shi Chiba 272 (JP)**
Inventor: **ABE, Masanori**
**6-705, Nishimine-machi 9-chome**
**Ota-ku Tokyo 146 (JP)**

(74) Representative: **Pilch, Adam John Michael et al**
**c/o D. Young & Co. 10 Staple Inn**
**London WC1V 7RD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 196 332 B1**

## Description

The present invention relates to a method of manufacturing a magneto-optic recording film wherein there is formed on a substrate a Bi-substituted rare-earth iron garnet film easily magnetizable along an axis normal to the film plane (hereinafter referred to as a vertically magnetized film).

Iron garnet $R_{3-x}Bi_x(Fe,M)_5O_{12}$ obtained by substituting Bi for R in a rare-earth iron garnet $R_3(Fe,M)_5O_{12}$ has recently been receiving much attention as a magneto-optic recording material. In the above formula, R is a rare-earth element, and M is an atom having a valence of 3 or a group of atoms having a valence equivalent to a valence of 3 such as $Al^{3+}$, $Ga^{3+}$, $Sc^{3+}$, $Tl^{3+}$, $(Co^{2+}+Ti^{4+})$ or the like. In the Bi-substituted rare-earth iron garnet, because some of the R atoms are replaced by Bi atoms, the Faraday rotation angle $\theta_F$ can be increased without much of an increase of the absorption coefficient $\alpha$ and, therefore, this material is generally an excellent magneto-optic recording material.

In order to improve the performance of the magneto-optic film of Bi-substituted rare-earth iron garnet, the Bi substitution amount x must be increased, to increase the Faraday rotation angle $\theta_F$. Conventionally, in a sintered ceramic of a rare-earth iron garnet, the Bi solid solution limit is known to be 50% of the dodecahedral sites of the crystal structure. Thus, monocrystalline films having a large Bi substitution amount x have been studied intensively.

A highly Bi-substituted rare-earth iron garnet thin film as described above is normally manufactured by the liquid phase epitaxy (LPE) method as described, for example, in J.J. A. P., *19* 2105 (1980). However, a magnetic thin film manufactured by the liquid phase epitaxy method, wherein the film composition is

$$Bi_{0.6}Sm_{1.2}Er_{1.2}Ga_{1.0}Fe_{4.0}O_{12},$$

has a small Faraday rotation angle $\theta_F$ of about 2.4 degree/μm at a light wavelength $\lambda=500$ nm at which the Faraday rotation angle is expected to be maximum value. Such a small Faraday rotation angle is impractical.

Further, with the LPE method, a Bi-substituted rare-earth iron garnet film must be formed on a single crystal substrate such as gadolinium gallium garnet $Gd_3Ga_5O_{12}$ (hereinafter referred to as a GGG substrate) which is high in cost.

In the LPE method, a thin film must be grown at a high temperature of about 800°C. However, since the vapour pressure of Bi is extremely high, i.e. about 133.322 Pa (1 Torr), Bi is selectively vaporized from the melt during thin film formation by the LPE method. According to an estimation made by the present inventors, the Bi substitution amount x in a monocrystalline thin film which has been formed by conventional LPE methods using a GGG substrate is at best about 20% of the dodecahedral sites of the rare-earth iron garnet.

A better method is one in which a highly Bi-substituted rare-earth iron garnet thin film is formed on an amorphous substrate such as a glass substrate. In most such methods, the Bi-substituted rare-earth iron garnet thin film formed on the amorphous substrate is a polycrystalline film having a magnetization axis parallel to the film plane. In EP—A—0 146 985 (prior art only by virtue of EPC Article 54(3)) and DE—A—1 940 640 there is disclosed a vertically magnetized film of Bi-substituted rare-earth iron garnet formed on an amorphous substrate. The film is deposited by sputtering as an amorphous film and is then crystallized by annealing.

According to the present invention, there is provided a method of manufacturing a magneto-optic recording film on a substrate, wherein a target consisting of an oxide containing at least Bi atoms, Fe atoms and rare-earth element atoms is sputtered, the atoms constituting the oxide which are released from the target by sputtering are deposited on the substrate which is held at a temperature of 500°C or lower, thereby forming an amorphous thin film, and annealing is performed so as to crystallize the amorphous thin film, thereby forming a vertically magnetized film of a Bi-substituted rare-earth iron garnet, characterized in that, prior to the annealing operation, a protective film for preventing vaporization of Bi is formed on the amorphous thin film. With this method, a vertically magnetized film of a Bi-substituted rare-earth iron garnet having a large Bi-substitution amount x, a very large Faraday rotation angle $\theta_F$, a sufficiently large coercive force $H_c$ and a sufficiently small absorption coefficient $\alpha$ is manufactured. This film has excellent magneto-optic recording characteristics.

Examples of the target consisting of an oxide containing at least Bi atoms, Fe atoms and rare-earth element atoms include targets having a general formula

$$(Bi_2O_3)_x(R_2O_3)_y(Fe_2O_3)_z(M_2O_3)_u$$

wherein $0<x\leq3/2$, $0<y\leq3/2$, $0<z<5/2$, and $0\leq u\leq5/2$, R is a rare-earth element such as Y or Sm, and M is $Al^{3+}$, $Ga^{3+}$, $Sc^{3+}$, $Tl^{3+}$, $(Co^{2+}+Ti^{4+})$ or the like.

Of such targets, a target wherein $0<y\leq3/2$, $1<(2/3)x+y\leq3/2$, $3/2<z\leq5/2$, and $z+u=5/2$ is preferable.

Although a sintered ceramic which is easy to handle is preferable as the target, the target is not limited to sintered ceramics. A mixture containing elements of the above formula can be used instead.

In order to form a thin film of a Bi-substituted rare-earth iron garnet having a single phase garnet structure by the above-mentioned sputtering method, the thin film composition must have the general formula

$$Bi_aR_b(Fe,M)_5O_{12} (0<a\leq3,\ 2<a+b\leq3).$$

If a+b is 2 or less, too many defects are formed and a single phase garnet structure cannot be obtained. A thin film formed by sputtering has a Bi

content lower than that of the target due to scattering of Bi during sputtering. Under the sputtering conditions used by the present inventors, the amount of Bi in the formed film is estimated to be about 2/3 of that in the target.

A thin film containing a large amount of Bi can be formed by using a target containing a larger amount of Bi. In order to form a thin film containing a larger amount of Bi than the solid solution limit, a target containing a large amout of Bi, e.g.,

$$Bi_aR_b(Fe,M)_5O_{12}(1.5<a\leq 9/2,\ 2<(2/3)a+b\leq 3)$$

is preferably used. When a target having the above composition is formed into a polycrystalline sintered ceramic, it will not consist of a single phase garnet structure but will be a mixture consisting of both the garnet phase and other impurity phases. However, such a target is preferably used since it has a high Bi content. In particular, the Bi substitution amount x is preferably 2 or more.

When sputtering onto any substrate (e.g. a glass substrate) other than a monocrystalline substrate is performed at a substrate temperature higher than 500°C, an amorphous thin film cannot be obtained, and a crystalline magnetic thin film having a roughened surface is directly formed. However, when an amorphous thin film is formed and is then annealed to crystallize the film the resulting film has a less rough surface.

The substrate temperature during formation of the amorphous thin film is preferably kept at 300 to 500°C and more preferably at 400 to 450°C. An amorphous thin film formed at a substrate temperature lower than 300°C tends to result in a magnetic thin film which develops surface roughness upon annealing and is not preferable.

As a result of the protective film formed on the amorphous thin film, surface roughness upon crystallization by annealing and vaporization of Bi are prevented, and a vertically magnetized film having a smoother surface is formed.

The substrate temperature must be 500°C or lower for the reasons described above. The protective film can be selected from various films which do not react with the underlying film at annealing temperatures of, e.g., about 700°C. Examples of such films may include oxide films such as $SiO_2$, ZnO, $TiO_2$, or $CeO_2$, nitride films such as $Si_3N_4$, and fluoride films such as $BaF_2$ or $CaF_2$. The thickness of the protective film is preferably 50 nm or more.

Annealing for crystallizing the amorphous thin film is preferably performed at a temperature of 500 to 900°C. When the annealing temperature is lower than 500°C, crystallization cannot be easily started, which is not desirable. However, when the annealing temperature is higher than 900°C, vaporization of Bi may occur and a reaction between the substrate and the thin film may occur, which is not desirable.

The invention will now be described by way of non-limiting example with reference to the accompanying drawings, in which:—

Fig. 1 is a sectional view showing a first step of manufacture of a magneto-optic recording film in accordance with the method of the present invention;

Fig. 2 is a sectional view showing a second stage of manufacture of the film of Fig. 1; and

Fig. 3 is a graph showing the hysteresis characteristics of a $(Y,Bi)_3(Fe,Al)_5O_{12}$ magneto-optic recording film.

$(Y,Bi)_3(Fe,Al)_5O_{12}$ is obtained by partially replacing Y in a yttrium iron garnet $Y_3Fe_5O_{12}$ (YIG) with Bi and partially replacing Fe with Al. When Y is partially replaced with Bi, the Faraday rotation angle $\theta_F$ is increased without much of an increase in the absorption coefficient $\alpha$. When Fe is partially replaced with Al, the absorption coefficient $\alpha$ and Curie temperature are decreased, and the saturation magnetization can be reduced to allow the easy manufacture of a vertically magnetized film.

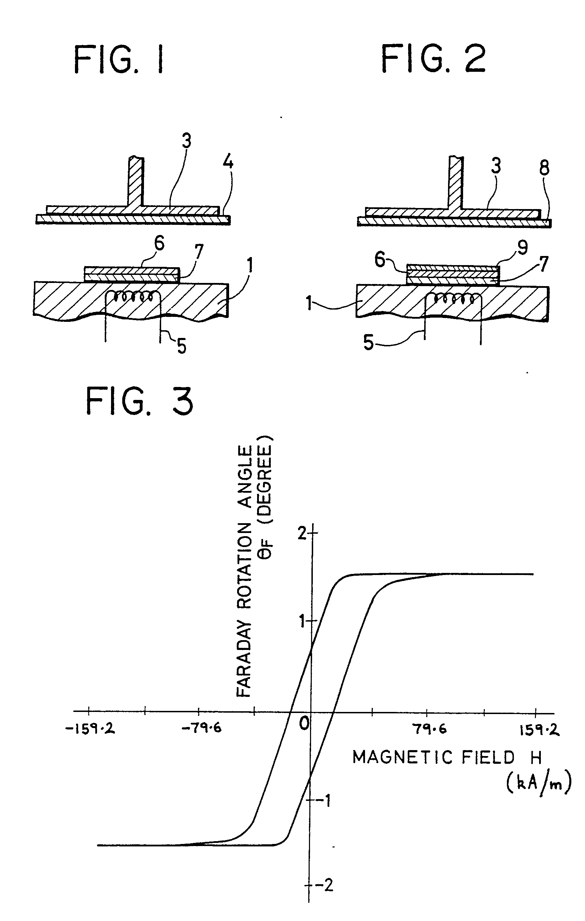

Referring to Fig. 1, amorphous quartz glass used as a substrate 7 is placed on an stainless steel electrode plate 1 also serving as a sample table of an RF sputtering apparatus. A target 4 is mounted on an electrode plate 3. The target 4 is a sintered ceramic disk of a polycrystalline iron garnet

$$(\text{composition: } Bi_{2.0}Y_{1.0}Fe_{3.8}Al_{1.2}O_{12})$$

with other impurity phases. Since a heater 5 is mounted on the electrode plate 1, the substrate 7 is heated to a predetermined temperature (e.g., 440°C) by the heater 5 through the electrode plate 1.

After the interior of the sputtering apparatus has been evacuated to a predetermined degree of vacuum, a mixture gas of Ar and $O_2$ ($Ar:O_2=9:1$) is supplied into the sputtering apparatus at a pressure of about 7 Pa. When the degree of vacuum is stabilized, a predetermined RF voltage is applied between the electrode plates 1 and 3 so as to start glow discharge. $Ar^+$ ions generated by discharge sputter the surface of the target 4, and this sputtering releases atoms such as Bi, Y, Fe, Al and O from the target 4. The released atoms are deposited on the substrate 7 which is heated to the predetermined temperature, and an amorphous thin film 6 of $(Y,Bi)_3(Fe,Al)_5O_{12}$ is deposited on the substrate 7. When the sputtering power was 110 W and the sputtering time was $2\frac{1}{2}$ hours, the thin film 6 had a thickness of 0.8 μm.

Then, as shown in Fig. 2, after replacing the target 4 mounted on the electrode plate 3 with a target 8 of $SiO_2$, similar sputtering is performed using the target 8, thereby forming an $SiO_2$ layer 9 on the thin film 6. During this film formation, the quartz glass substrate 7 is held at room temperature. When the sputtering power was 200 W and the sputtering time was 30 minutes, the resulting $SiO_2$ layer 9 had a thickness of 0.5 μm.

A sample having a three-layered structure consisting of the quartz glass substrate 7, the thin film 6 and the $SiO_2$ layer 9 was annealed in air at 700°C for 3 hours in order to crystallize the amorphous

thin film 6.

When X-ray diffractometry was performed, the thin film 6 manufactured in this manner had no preferred orientation. When the film 6 was observed through an optical microscope, although it was polycrystalline it was found to have an arabesque bubble-like magnetic domain structure and to be an excellent vertically magnetized film having the excellent characteristics shown in Fig. 3.

More specifically, as shown in Fig. 3, the hysteresis of the Faraday rotation angle $\theta_F$ of the thin film 6 as a function of a magnetic field H applied along a direction perpendicular to the film plane exhibited an excellent squareness. The magnetic torque measurement revealed that the film is a vertically magnetized film. The film has a large Faraday rotation angle $\theta_F$ of about 1.5 degrees and a sufficiently large coercive force $H_c$ of about 16 kA/m (200 Oe). Thus, the thin film 6 has very desirable properties as a magneto-optic recording material. These may indicate that the film 6 contains a large amount of Bi up to its solid solution limit, applying a large perpendicular magnetic anisotropy. In Fig. 3, the light source for measuring the Faraday rotation angle $\theta_F$ was a He—Ne laser (wavelength: 632.8 nm=6328 Å). The measurement was performed by transmitting light through the thin film 6. Due to the presence of the protective film constituted by the $SiO_2$ layer 9, out-diffusion of atoms such as Bi contained in the thin film 6 and surface roughening during annealing are prevented, and growth of crystal grains of the thin film 6 is suppressed.

Thus, a polycrystalline vertically magnetized film having excellent vertical magnetization characteristics is formed on a quartz glass substrate 7 in an efficient manner. In addition, due to the presence of the $SiO_2$ layer 9 as a protective film, surface roughness of the thin film 6 resulting from annealing to crystallize the film is largely prevented. Since out-diffusion of Bi from the thin film 6 during annealing is prevented by the $SiO_2$ layer 9, the annealing temperature can be set to be higher than would otherwise be the case.

## Claims

1. A method of manufacturing a magneto-optic recording film (6, 9) on a substrate (7), wherein a target (4) consisting of an oxide containing at least Bi atoms, Fe atoms and rare-earth element atoms is sputtered, the atoms constituting the oxide which are released from the target (4) by sputtering thereby being deposited on the substrate (7) which is held at a temperature of 500°C or lower, thereby forming an amorphous thin film (6), and annealing is performed so as to crystallize the amorphous thin film (6), thereby forming a vertically magnetized film (6) of a Bi-substituted rare-earth iron garnet, characterized in that, prior to the annealing operation, a protective film (9) for preventing vaporization of Bi is formed on the amorphous thin film (6).

2. A method according to claim 1, wherein the target (4) comprises

$$(Bi_2O_3)_x(R_2O_3)_y(Fe_2O_3)_z(M_2O_3)_u$$

and R is a rare-earth element, M is an atom having a valence of 3 or a group of atoms having a valence equivalent to a valence of 3, and $0<y\leq3/2$, $1<(2/3)x+y\leq3/2$, $3/2<z\leq5/2$, and $z+u=5/2$.

3. A method according to claim 1, wherein the target (4) is a sintered ceramic consisting of coexisting multiple phases of

$$Bi_aR_b(Fe,M)_5O_{12},$$

where R is a rare-earth element, M is an atom having a valence of 3 or a group of atoms having a valence equivalent to a valence of 3, and $1.5<a\leq9/2$ and $2<(2/3)a+b\leq3$.

4. A method according to claim 2 or claim 3, wherein the atom having a valence of 3 or the group of atoms having a valence equivalent to a valence of 3 represented by M is selected from the group consisting of $Al^{3+}$, $Ga^{3+}$, $Sc^{3+}$, $Tl^{3+}$, and $(Co^{2+}+Ti^{4+})$.

5. A method according to any one of claims 1 to 4, wherein the substrate (7) is a glass substrate (7).

6. A method according to any one of claims 1 to 5, wherein the substrate temperature is 300 to 500°C.

7. A method according to any one of claims 1 to 5, wherein the substrate temperature is 400 to 450°C.

8. A method according to any one of claims 1 to 7, wherein the annealing temperature is 500 to 900°C.

9. A method according to any one of claims 1 to 8 wherein the protective film (9) is an $SiO_2$ film, a ZnO film, a $TiO_2$ film, a $CeO_2$ film, a $Si_3N_4$ film, a $BaF_2$ film or a $CaF_2$ film.

10. A method according to any one of claims 1 to 9, wherein the protective film (9) has a thickness of 50 nm or more.

## Patentansprüche

1. Verfahren zur Herstellung einer magnetooptischen Aufzeichnungsschicht (6, 9) auf einem Substrat (7), bei dem ein aus einem wenigstens Wismut (Bi)-und Eisenatome (Fe) und Selten-Erdatome enthaltenden Oxid bestehendes Target (4) gesputtert wird und die aus dem Target (4) durch das Sputtern freigesetzten Atome des Oxids auf dem auf einer Temperatur von 500°C oder darunter gehaltenen Substrat (7) niedergeschlagen werden und eine amorphen dünne Schicht (6) bilden und bie dem eine Wärmebehandlung zur Kristallisation der amorphe dünnen Schicht (6) durchgeführt wird, wodurch eine senkrecht magnetisierte Schicht (6) aus einem Bisubstituierten Selten-Erd-Eisen-Granat erzeugt wird, dadurch gekennzeichnet, daß vor der Wärmebehandlung eine Schutzschicht (9) auf der amorphen dünnen Schicht (6) zur Verhinderung der Verdampfung des Bi aufgebracht wird.

2. Verfahren nach Anspruch 1, bei denn das Target (4)

$$(Bi_2O_3)_x(R_2O_3)_y(Fe_2O_3)_z(M_2O_3)_u$$

enthält, worin R ein Seiten-Erdelement, M ein Atom mit einer Wertigkeit von 3 oder eine Gruppe von Atomen mit einer der Wertigkeit von 3 entsprechenden Wertigkeit bezeichnet und $0<y\leq 3/2$, $1<(2/3)x+y\leq 3/2$, $3/2<z\leq 5/2$ und $z+u=5/2$ gilt.

3. Verfahren nach Anspruch 1, bei dem das Target (4) eine gesinterte Keramik ist, bestehend aus ko-existierenden multiplen Phasen aus

$$Bi_aR_b(Fe,M)_5O_{12}$$

in denen R ein Selten-Erdelement Mein Atom mit einer Wertigkeit von 3 oder eine Gruppe von Atomen mit einer Wertigkeit von 3 entsprechenden Wertigkeit und $1,5<a\leq 9/2$ und $2<(2/3)a+b\leq 3$ ist.

4. Ein Verfahren nach Anspruch 2 oder 3, bei dem M, definiert als Atom mit der Wertigkeit 3 oder als Gruppe von Atomen mit einer der Wertigkeit von 3 entsprechenden Wertigkeit, aus einer Gruppe, bestehend aus $Al^{3+}$, $Ga^{3+}$, $Sc^{3+}$, $Tl^{3+}$ und $(Co^{2+}+Ti^{4+})$, aus gewählt ist.

5. Ein Verfahren nach einem der Ansprüche 1 bis 4, bei dem das Substrat (7) ein Glassubstrat (7) ist.

6. Ein Verfahren nach einem der Ansprüche 1 bis 5, bei dem die Substrattemperatur 300 bis 500°C beträgt.

7. Ein Verfahren nach einem der Ansprüche 1 bis 5, bei dem die Substrattemperatur 400 bis 450°C beträgt.

8. Ein Verfahren nach einem der Ansprüche 1 bis 7, bei dem die Wärmebehandlungstemperatur 500 bis 900°C beträgt.

9. Ein Verfahren nach einem der Ansprüche 1 bis 8, bei dem die Schutzschicht (9) eine $SiO_2$-Schicht, eine ZnO-Schicht, eine $TiO_2$-Schicht, eine $CeO_2$-Schicht, eine $Si_3N_4$-Schicht, eine $BaF_2$-Schicht oder eine $CaF_2$-Schicht ist.

10. Ein Verfahren nach einem der Ansprüche 1 bis 9, bei dem die Schutzschicht (9) eine Dicke von 50 nm oder mehr hat.

**Revendications**

1. Procédé de fabrication d'un film d'enregistrement magnéto-optique (6, 9) sur un substrat (7), dans lequel on soumet à un processus de projection de particules une cible (4) constituée d'un oxyde contenant au moins des atomes de Bi (bismuth), des atomes de Fe (fer) et des atomes d'un élément de terre rare, les atomes, constituant l'oxyde qui sont libérés de la cible (4) par le processus de projection de particules, étant ainsi déposé sur le substrat (7) maintenu à une température de 500°C ou moins, pour former ainsi un film mince amorphe (6), puis un recuit étant ensuite effectué de manière à cristalliser le film mince amorphe (6) pour former ainsi un film magnétisé verticalement (6) d'un grenat de fer à terre rare dans lequel on a substitué des atomes de Bi à des atomes de terre rare, procédé caractérisé en ce qu'avant l'opération de recuit, on forme sur le film mince amorphe (6) un film protecteur (9) destiné à empêcher la vaporisation du Bi.

2. Procédé selon la revendication 1, caractérisé en ce que la cible (4) est constitué de

$$(Bi_2O_3)_x(R_2O_3)_y(Fe_2O_3)_z(M_2O_3)_u,$$

dans lequel R est un élément de terre rare, M est un atome de valence 3 ou un groupe d'atomes de valence équivalente à une valeur 3; et $0<y\leq 3/2$, $1<(2/3)x+y\leq 3/2$; $3/2<z\leq 5/2$; avec $z+u=5/2$.

3. Procédé selon la revendication 1, caractérisé en ce que la cible (4) est une céramique agglomérée constituée de phases multiples coexistantes de

$$Bi_aR_b(Fe,M)_5O_{12},$$

où R est un élément de terre rare, M est un atome de valence 3 ou un groupe d'atomes de valence équivalente à une valeur 3 et $1,5<a\leq 9/2$ avec $2<(2/3)a+b\leq 3$.

4. Procédé selon l'une quelconque des revendications 2 et 3, caractérisé en ce que l'atome de valence 3 ou le groupe d'atomes de valence équivalent à une valence 3, représenté par M, est sélectionné dans le groupe constitué de $Al^{3+}$, $Ga^{3+}$, $Sc^{3+}$, $Ti^{3+}$ et $(Co^{2+}+Ti^{4+})$.

5. Procédé selon l'une quelconque des revendications 1 à 4, caractérisé en ce que le substrat (7) est un substrat de verre (7).

6. Procédé selon l'une quelconque des revendications 1 à 5, caractérisé en ce que la température du substrat est de 300 à 500°C.

7. Procédé selon l'une quelconque des revendications 1 à 5, caractérisé en ce que la température du substrat est de 400 à 450°C.

8. Procédé selon l'une quelconque des revendications 1 à 7, caractérisé en ce que la température de recuit est de 500 à 900°C.

9. Procédé selon l'une quelconque des revendications 1 à 8, caractérisé en ce que le film protecteur (9) est un film de $SiO_2$, un film de ZnO, un film de $TiO_2$, un filme de $CeO_2$, un film de $Si_3N_4$, un filme de BaFe ou un film de $CaF_2$.

10. Procédé selon l'une quelconque des revendications 1 à 9, caractérisé en ce que le film protecteur (9) présente une épaisseur de 50 mm ou plus.

FIG. 1

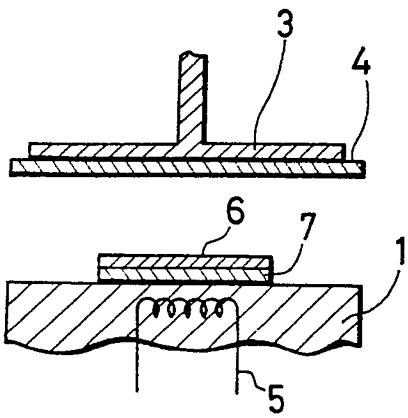


FIG. 2

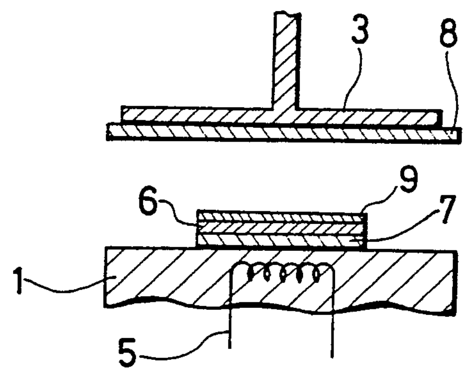


FIG. 3